(19) Europäisches Patentamt
European Patent Office
Office européen des brevets

(11) **EP 3 459 125 B1**

(12) **FASCICULE DE BREVET EUROPEEN**

(45) Date de publication et mention
de la délivrance du brevet:
**06.01.2021 Bulletin 2021/01**

(21) Numéro de dépôt: **17726236.7**

(22) Date de dépôt: **19.05.2017**

(51) Int Cl.:
**H01L 39/22** *(2006.01)*

(86) Numéro de dépôt international:
**PCT/EP2017/062194**

(87) Numéro de publication internationale:
**WO 2017/198866 (23.11.2017 Gazette 2017/47)**

(54) **DISPOSITIF COMPRENANT UNE JONCTION JOSEPHSON**

VORRICHTUNG MIT EINEM JOSEPHSON-ÜBERGANG

DEVICE COMPRISING A JOSEPHSON JUNCTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.05.2016 FR 1600816**

(43) Date de publication de la demande:
**27.03.2019 Bulletin 2019/13**

(73) Titulaires:
• **Thales**
  **92400 Courbevoie (FR)**
• **Centre National de la Recherche Scientifique**
  **75016 Paris (FR)**

(72) Inventeurs:
• **VILLEGAS, Javier**
  **92140 Clamart (FR)**
• **BEGON-LOURS, Laura**
  **75007 Paris (FR)**
• **TRASTOY QUINTELA, Juan**
  **La Jolla, CA 92037 (US)**
• **CRETE, Denis**
  **91767 Palaiseau (FR)**

(74) Mandataire: **Lavoix**
  **2, place d'Estienne d'Orves**
  **75441 Paris Cedex 09 (FR)**

(56) Documents cités:
**FR-A1- 2 954 855          JP-A- H06 334 231**
**US-A1- 2015 380 631**

• **YANG Q ET AL: "The structural and superconducting properties in the YBa2Cu3O7-d/BiFeO3 heterostructures", PHYSICA C, vol. 492, 11 juillet 2013 (2013-07-11), pages 181-185, XP028691647, ISSN: 0921-4534, DOI: 10.1016/J.PHYSC.2013.07.001**
• **NAVARRO H ET AL: "Characterization of the insulator barrier and the superconducting transition temperature in GdBa2Cu3O7-d/BaTiO3 bilayers for application in tunnel junctions", JOURNAL OF APPLIED PHYSICS, vol. 118, no. 4, 045308, 28 juillet 2015 (2015-07-28), XP012199384, ISSN: 0021-8979, DOI: 10.1063/1.4927751 [extrait le 1901-01-01]**
• **Bégon-Lours L: "Ferroelectric Field-Effects in High-Tc Superconducting Devices", Thesis Université Pierre et Marie Curie - Paris V , 23 janvier 2017 (2017-01-23), XP055395364, Paris Extrait de l'Internet: URL:http://hal.upmc.fr/tel-01522923/ [extrait le 2017-08-02]**

**Description**

La présente invention concerne un dispositif électronique comprenant une jonction Josephson, un transistor comprenant un tel dispositif, ainsi qu'un procédé d'utilisation d'un tel dispositif.

La supraconductivité est la particularité, pour certains matériaux dits supraconducteurs, de présenter une résistance électrique nulle lorsque leur température est inférieure à une température critique. La supraconductivité a été découverte en 1911 par le physicien néerlandais Heike Kamerlingh Onnes, qui constata que la résistance au courant électrique continu d'un fil de mercure s'annulait en dessous de 4,2 Kelvin (K). La supraconductivité est causée par la formation, dans le matériau, de paires de Cooper formées de deux électrons. Le gaz de porteurs de charge est décrit macroscopiquement par une fonction d'onde quantique présentant une phase $\theta$.

Depuis 1911, de nombreux efforts de recherche ont été dédiés à l'obtention de matériaux supraconducteurs présentant une température critique plus élevée, facilitant la mise en application de matériaux supraconducteurs. En effet, la supraconductivité disparaît brusquement lorsque la température du matériau est supérieure à la température critique, ce qui implique fréquemment l'utilisation de systèmes cryogéniques perfectionnés.

Les jonctions Josephson comportant des matériaux supraconducteurs sont une composante de nombreux dispositifs électroniques. Une jonction Josephson est formée par l'empilement de deux couches supraconductrices séparées par une couche barrière non supraconductrice. La couche barrière est suffisamment fine pour que les paires de Cooper puissent la traverser, et donc transiter d'une couche supraconductrice à l'autre, par effet tunnel si la couche barrière est isolante électriquement, ou par transport électronique classique dans le cas contraire.

En effet, selon l'effet Josephson, la fonction d'onde des paires de Cooper de la première couche supraconductrice s'étend à travers la couche barrière, jusque dans la seconde couche supraconductrice où elle interfère avec la fonction d'onde des paires de Cooper de la seconde couche supraconductrice.

Un dispositif comprenant une jonction tunnel supraconductrice Josephson ayant une couche barrière multiferroïque est décrit par le document US 2015/380631 A1. L'article de Yang et al. intitulé « The structural and superconducting properties in the YBa2Cu307-d/BiFeO3 heterostructures » paru dans Physica C 492, p.181-185, l'article de Navarro et al. intitulé « Characterization of the insulator barrier and the superconducting transition temperature in GdBa2Cu307-d/BaTiO3 bilayers for application in tunnel junctions" paru dans JAP 118, 045308 et JP H06 334231 A décrivent des jonctions tunnel à barrière ferroélectrique.

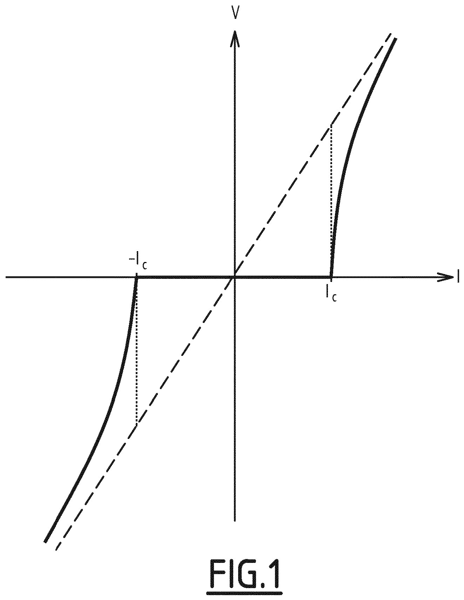

La caractéristique courant - tension d'une jonction Josephson, dont le matériau intermédiaire composant la couche barrière est un métal non supraconducteur, est représentée de manière schématique à la figure 1.

On montre que le courant $I$ et la tension V prennent la forme paramétrique suivante :

$$I = \frac{\phi_0}{2\pi R}\frac{d\varphi}{dt} + I_c \sin\varphi \qquad \text{(Equation 1)}$$

$$V = \frac{\phi_0}{2\pi}\frac{d\varphi}{dt} \qquad \text{(Equation 2)}$$

Où

- le paramètre $\varphi = \theta_1 - \theta_2$ correspond à la différence entre les phases des fonctions d'ondes des paires de Cooper dans les première et seconde couches supraconductrices, respectivement ;
- $\Phi_0$ est une constante caractéristique de l'effet Josephson et s'exprime en fonction de la constante de Planck $h$ et de la charge de l'électron e selon : $\phi_0 = \dfrac{h}{2e}$ ;
- R est dénommée résistance normale et correspond à la pente des branches asymptotiques de la caractéristique courant - tension ;
- t représente le temps ; et,
- $I_c$ est un courant critique, caractéristique de la jonction Josephson.

Il existe une solution pour laquelle la différence de phase $\varphi$ est constante dans le temps. La tension V est nulle, mais un courant continu peut être mis en circulation à travers la jonction Josephson. Ce courant continu est inférieur à $I_c$, à cause du terme en $\sin\varphi$ dans l'équation (1).

Il existe également une solution pour laquelle la tension V est constante et non nulle. La différence de phase est alors une fonction monotone croissante en fonction du temps. Un courant oscillant en $\sin\varphi$ traverse la jonction

Josephson.

On notera, sans rentrer dans les détails, que le courant critique $I_c$ est une fonction de la composante du champ magnétique dans un plan transverse à la direction d'empilement des couches de la jonction Josephson.

Lorsqu'une différence de potentiel fixe est appliquée aux bornes d'une jonction Josephson, il est généré un courant électrique de paires de Cooper sinusoïdal traversant la jonction. La fréquence du courant est fixée par la tension V aux bornes de la jonction. De telles jonctions sont utilisées dans des détecteurs de champ magnétique très sensibles appelés SQUIDs (de l'Anglais « Superconducting QUantum Interference Device »), ainsi que dans des transistors.

Cependant, le courant électrique généré par la jonction Josephson est peu ajustable.

Il existe donc un besoin pour un dispositif électronique, comprenant une jonction Josephson, propre à générer un courant électrique qui soit plus ajustable.

A cet effet, il est proposé un dispositif électronique selon la revendication 1.

Suivant un mode de réalisation particulier, le dispositif est selon l'une quelconque des revendications 2 à 8.

Il est également proposé un transistor selon la revendication 9.

Les caractéristiques et avantages de l'invention apparaîtront à la lecture de la description qui va suivre, donnée uniquement à titre d'exemple non limitatif, et faite en référence aux dessins annexés, sur lesquels :

- la figure 1 est un exemple de caractéristique courant-tension d'une jonction Josephson dans laquelle la couche barrière est réalisée en métal,
- la figure 2 est une représentation schématique d'un dispositif comprenant un empilement de couches supraconductrices et non supraconductrices superposées selon une direction d'empilement,
- les figures 3 et 4 sont des vues en coupe d'un empilement selon la figure 2 selon une direction perpendiculaire à la direction d'empilement.

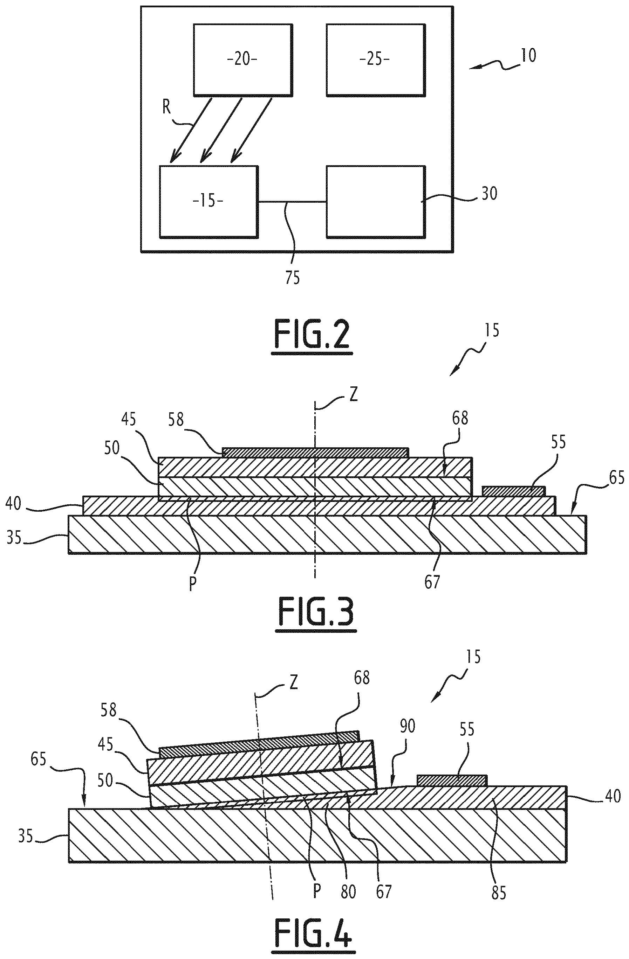

Un dispositif 10 est représenté sur la figure 2.

Le dispositif 10 est un dispositif électronique. Cela signifie que le dispositif 10 est propre à générer, à recevoir ou à modifier des signaux électriques.

Le dispositif 10 est propre à générer au moins un courant électrique.

Le dispositif 10 comprend un empilement 15 de couches superposées, un module d'émission 20 d'un rayonnement R, un organe de régulation 25 et un organe de contrôle 30.

Un premier exemple d'empilement 15 est représenté sur la figure 3.

L'empilement 15 comprend un ensemble de couches superposées selon une direction d'empilement.

La direction d'empilement est notée « Z », et représentée sur les figures 3 et 4 par une ligne pointillée.

L'empilement 15 comprend un substrat 35, une première couche 40, une deuxième couche 45, une couche barrière 50, une première électrode 55 et une deuxième électrode 58.

Le substrat 35 présente une première face 65.

La première face 65 est plane.

La première face 65 est perpendiculaire à la direction d'empilement Z.

En variante, la première face 65 présente une courbure. Par exemple, le substrat 35 est un substrat souple propre à être déformé au cours d'une utilisation. Selon un autre exemple, le substrat 35 est un substrat rigide ayant subi une érosion non uniforme au cours d'un procédé d'usinage.

Le substrat 35 est électriquement isolant.

Par exemple, le substrat 35 est réalisé en titanate de strontium $SrTiO_3$.

Le substrat 35 présente, par exemple, une structure cristalline telle que la pérovskite. La structure pérovskite est une structure cristalline commune à de nombreux oxydes.

La première couche 40 présente une largeur selon une première direction perpendiculaire à la direction d'empilement Z, et une longueur selon une deuxième direction perpendiculaire à la première direction et à la direction d'empilement Z.

La première couche 40 est sensiblement planaire. Cela signifie que la longueur et la largeur sont, chacune, supérieures ou égales à dix fois l'épaisseur de la première couche 40.

La première couche 40 est perpendiculaire à la direction d'empilement Z. Cela signifie que la première direction et la deuxième direction sont perpendiculaires à la direction d'empilement Z, à 10 degrés (°) près.

La première couche 40 présente une première épaisseur e1. La première épaisseur e1 est, par exemple, comprise entre 2 nanomètres (nm) et 10 microns ($\mu$m), de préférence comprise entre 5 nm et 50 nm. Toutes les épaisseurs sont mesurées selon la direction d'empilement Z.

La première épaisseur e1 est uniforme.

Il est entendu par l'expression « épaisseur uniforme » d'une couche que, lorsque l'épaisseur est définie comme étant la longueur d'un segment parallèle à la direction d'empilement Z et reliant un premier point d'une première surface de la couche à un deuxième point d'une deuxième surface de la couche, l'épaisseur est inchangée, à dix pourcents près, lorsque la position du premier point sur la première surface est modifiée.

La première couche 40 et le substrat 35 sont superposés selon la direction d'empilement Z.

La première couche 40 est délimitée, selon la direction d'empilement Z, par le substrat 35 et par la couche barrière 50.

La première couche 40 est réalisée en un premier matériau supraconducteur M1.

Le premier matériau M1 présente une première résistivité R1, dépendante de la température.

La résistivité d'un matériau est définie comme étant la résistance électrique d'un tronçon de matériau de 1 mètre (m) de longueur et de 1 $m^2$ de section. La résistivité est, généralement, exprimée en ohm·mètre ($\Omega$·m). La résistance électrique mesurée entre deux contacts est définie comme le rapport entre la tension mesurée aux bornes des deux contacts et le courant électrique circulant dans une branche de circuit passant par les deux bornes.

Il est entendu par le terme « matériau supraconducteur » que le premier matériau M1 présente une première température critique Tc1. Lorsque le premier matériau M1 est à une température inférieure ou égale à la première température critique Tc1, la première résistivité R1 est égale à zéro.

Le premier matériau M1 est un supraconducteur présentant une longueur d'écrantage du champ électrique. Dans le cadre de l'approximation de Thomas-Fermi, la longueur d'écrantage est nommée longueur de Thomas-Fermi.

La longueur de Thomas-Fermi est supérieure à 0.1 nm. Il est défini, pour le premier matériau M1, une concentration en porteurs de charges. Les porteurs de charge sont, par exemple, des particules telles que des électrons, ou des pseudoparticules telles que des trous. A chaque porteur de charge est associée une charge électrique.

La concentration de porteurs de charge est définie comme étant la somme des charges électriques de chaque porteur de charge par unité de volume de premier matériau M1.

La première température critique Tc1 dépend fortement de la concentration de porteurs de charge dans le matériau premier matériau M1. Par exemple une variation de l'ordre de $5.10^{20}$ électrons par centimètre cube fait varier la première température critique Tc1 de quelques dizaines de Kelvin.

De préférence, le matériau M1 est un matériau de la famille des cuprates. Les cuprates sont des composés chimiques contenant des cations cuivre. De nombreux composés de la famille des cuprates présentent les propriétés décrites ci-dessus.

Par exemple, le premier matériau M1 est un oxyde mixte de baryum, de cuivre, et d'yttrium. Les oxydes mixtes de baryum, de cuivre et d'yttrium, également notés YBCO sont des composés chimiques cristallins présentant fréquemment la formule chimique $YBa_2Cu_3O_{7-\delta}$, dans laquelle $\delta$ est un nombre réel supérieur ou égal à zéro. De préférence, $\delta$ est compris entre 0 et 0,6.

Le premier matériau M1 présente, par exemple, une structure de type pérovskite. La pérovskite est une structure cristalline commune à de nombreux oxydes. Lorsque le premier matériau M1 présente une structure de type pérovskite, il est défini, pour le premier matériau M1, un premier axe a, un deuxième axe b et un troisième axe c. Le premier axe a, le deuxième axe b et le troisième axe c sont des axes définis de manière usuelle pour de nombreuses structures cristallines, avec des notations fréquemment utilisées dans la littérature.

Le troisième axe c du premier matériau M1 est parallèle à la direction d'empilement Z.

La deuxième couche 45 est sensiblement planaire.

La deuxième couche 45 est perpendiculaire à la direction Z.

La deuxième couche 45 présente une deuxième épaisseur e2. La deuxième épaisseur e2 est, par exemple, comprise entre 2 nanomètres (nm) et 10 microns ($\mu$m), de préférence comprise entre 5 nm et 50 nm.

La deuxième couche 45 est délimitée selon la direction d'empilement Z par la couche barrière 50.

La couche barrière 50 et la deuxième couche 45 sont superposées.

La deuxième couche 45 est réalisée en un deuxième matériau M2. Le deuxième matériau M2 est un matériau supraconducteur.

La deuxième couche 45 présente une deuxième température critique Tc2.

De préférence, le deuxième matériau M2 est différent du premier matériau M1.

Par exemple, le deuxième matériau M2 est le niobium Nb.

La couche barrière 50 est sensiblement planaire.

La couche barrière 50 est perpendiculaire à la direction d'empilement Z.

La couche barrière 50 est délimitée, selon la direction d'empilement Z, par la première couche 40 et par la deuxième couche 45.

La couche barrière 50 et la première couche 40 sont superposées selon la direction d'empilement Z.

La couche barrière 50 est configurée pour former, avec la première couche 40 et la deuxième couche 45, une jonction Josephson. Cela signifie que la couche barrière 50 est propre à permettre le transfert de paires de Cooper depuis la première couche 40 vers la deuxième couche 45, et réciproquement depuis la deuxième couche 45 vers la première couche 40.

Par exemple, la couche barrière 50 est propre à permettre le transfert de paires de Cooper depuis la première couche 40 vers la deuxième couche 45, et réciproquement depuis la deuxième couche 45 vers la première couche 40, par conduction électrique. En variante, la couche barrière 50 est propre à permettre le transfert de paires de Cooper depuis la première couche 40 vers la deuxième couche 45, et réciproquement depuis la deuxième couche 45 vers la première couche 40, par effet tunnel.

Il est défini, pour l'empilement 15, un courant critique Ic d'après l'équation 1.

La couche barrière 50 présente une troisième épaisseur e3.

Par exemple, la troisième épaisseur e3 est strictement inférieure à 5 nm.

En variante, la troisième épaisseur e3 est comprise entre 5 nm et 50 nm.

La couche barrière 50 présente une deuxième face 67 et une troisième face 68.

La deuxième face 67 est perpendiculaire à la direction d'empilement Z. La deuxième face 67 est plane.

La troisième face 68 est perpendiculaire à la direction d'empilement Z. La troisième face 68 est plane.

La couche barrière 50 est réalisée en un troisième matériau M3.

Il est défini, pour le troisième matériau M3, une polarisation électrique PE. Cela signifie que le troisième matériau M3 présente une pluralité de dipôles électriques générant chacun un moment électrique, et la polarisation électrique PE est définie comme étant la moyenne, par unité de volume, des moments électriques. La polarisation électrique PE est donc une grandeur vectorielle.

Le troisième matériau M3 est un matériau ferroélectrique.

Cela signifie que la polarisation PE est non nulle en l'absence de champ électrique extérieur. En d'autres termes, le barycentre des charges positives et le barycentre des charges négatives dans la couche barrière 50 ne sont pas confondus, même en l'absence de champ électrique extérieur.

La polarisation PE est mobile entre une première orientation O1 et une deuxième orientation O2.

Lorsque la polarisation PE est dans la première orientation O1, la polarisation PE présente au moins une composante parallèle à la direction d'empilement Z. Cela signifie que la première orientation O1 n'est pas perpendiculaire à la direction d'empilement Z.

Lorsque la polarisation PE est dans la deuxième orientation O2, la polarisation PE présente au moins une composante parallèle à la direction d'empilement Z. La composante est de sens opposé au sens de la première orientation O1.

De préférence, la première orientation O1 est parallèle à la direction d'empilement Z.

Par exemple, lorsque la polarisation PE est dans la première orientation O1, la polarisation PE est dirigée vers la première couche 40.

Le troisième matériau M3 présente une valeur de gap G.

Il est entendu par « valeur de gap » d'un matériau la valeur de la largeur de la bande d'énergie interdite entre la bande de valence et la bande de conduction dans le matériau. La valeur de gap d'un matériau est, par exemple, exprimée en électron-volts (eV).

La bande de valence est définie comme étant, parmi les bandes d'énergie permises pour des trous dans le matériau, la bande qui présente l'énergie la plus haute tout en étant remplie complétement à une température de 0 K.

La bande de conduction est définie comme étant, parmi les bandes d'énergie permises pour des électrons dans le matériau, la bande qui présente l'énergie la plus basse tout en n'étant pas entièrement remplie à une température de 0 K.

Le troisième matériau M3 n'est pas supraconducteur. De préférence, le troisième matériau M3 est électriquement isolant.

Le troisième matériau M3 est, par exemple, la ferrite de bismuth $BiFeO_3$. Lorsque le troisième matériau M3 est la ferrite de bismuth $BiFeO_3$, la valeur de gap G est égale à 2,8 eV.

La première électrode 55 est configurée pour recevoir de l'organe de polarisation 30 un premier courant électrique C1 et pour transmettre le premier courant C1 à la première couche 40.

La première électrode 55 est sensiblement planaire.

La première électrode 55 est perpendiculaire à la direction d'empilement Z. La première électrode 55 est délimitée selon la direction d'empilement Z par la première couche 40.

La première électrode 55 est réalisée en un matériau électriquement conducteur. De préférence, la première électrode 55 est réalisée en un matériau métallique tel que l'or ou le cuivre.

La deuxième électrode 58 est configurée pour recevoir de la deuxième couche 45 le premier courant C1 et pour transmettre le premier courant C1 à l'organe de polarisation 30.

La deuxième électrode 58 est sensiblement planaire.

La deuxième électrode 58 est perpendiculaire à la direction d'empilement Z. La deuxième électrode 58 est délimitée selon la direction d'empilement Z par la deuxième couche 45.

La deuxième électrode 58 est réalisée en un matériau électriquement conducteur. De préférence, la deuxième électrode 58 est réalisée en un matériau métallique tel que l'or ou le cuivre.

Le module d'émission 20 est propre à illuminer l'empilement 15 avec un rayonnement électromagnétique R.

Par exemple, le module d'émission 20 est configuré pour générer le rayonnement R. Cela signifie que le module d'émission 20 comprend une source primaire de rayonnement.

Par exemple, le module d'émission 20 comprend une diode laser portée par le substrat 35. La diode laser est propre à émettre le rayonnement R selon une direction perpendiculaire à la direction d'empilement Z.

En variante, le module d'émission 20 comprend une diode électroluminescente et un guide d'ondes, tel qu'une fibre optique, propre à transmettre le rayonnement R entre la diode et l'empilement 15.

Le rayonnement R présente au moins une onde électromagnétique Oe. L'onde électromagnétique Oe présente une fréquence de rayonnement Fr. La fréquence de rayonnement Fr est définie comme étant égale au rapport entre la célérité c de la lumière dans le vide et la longueur d'onde de l'onde électromagnétique Oe dans le vide.

Le rayonnement R présente une énergie photonique E. L'énergie photonique E est définie comme étant le produit de la constante de Planck et de la fréquence de rayonnement Fr.

Le rayonnement R est un rayonnement visible. Cela signifie que l'énergie E est comprise strictement entre 1,59 eV et 3,18 eV.

Par exemple, le rayonnement R est un rayonnement violet. Cela signifie que l'énergie E est comprise strictement entre 2,74 eV et 3,18 eV.

En variante, le rayonnement R est un rayonnement ultra-violet, c'est-à-dire que l'énergie E est comprise strictement entre 3,2 eV et 124 eV.

Le rayonnement R est propre à être absorbé par la couche barrière 50. Cela signifie que l'énergie E est strictement supérieure à la valeur de gap G de la couche barrière 50.

Par exemple, lorsque le troisième matériau M3 est la ferrite de Bismuth, l'énergie E est strictement supérieure à 2,8 eV.

Le rayonnement R présente une densité de puissance Pu. La densité de puissance Pu est la quantité d'énergie apportée chaque seconde par le rayonnement R sur une surface de 1 mètre carré (m$^2$) que le rayonnement R traverse. La densité de puissance Pu est fréquemment exprimée en watt par centimètres carrés (W/cm$^2$).

Par exemple, la densité de puissance Pu est comprise entre 5 microwatts par centimètres carrés ($\mu$W/cm$^2$) et 100 milliwatts par centimètres carrés (mW/cm$^2$)

L'organe de régulation 25 est configuré pour maintenir l'empilement 15 à une température de consigne Ta.

La température de consigne Ta est strictement inférieure à la plus basse des première et deuxième températures critiques Tc1 et Tc2.

Par exemple, l'organe de régulation 25 comprend un module de réfrigération utilisant l'effet Joule-Thomson. En physique, l'effet Joule-Thomson, également appelé effet Joule-Kelvin, est un phénomène lors duquel la température d'un gaz diminue lorsque le gaz subit une expansion adiabatique.

En variante, l'organe de régulation 25 comprend une réserve de fluide réfrigérant (tel que l'azote liquide ou l'hélium liquide).

L'organe de polarisation 30 est propre à modifier la température critique Tc1 d'une portion P de la première couche 40.

De préférence, l'organe de polarisation 30 est configuré pour modifier la température critique Tc1 de la portion P entre une première valeur T1 et une deuxième valeur T2.

La première valeur T1 est strictement inférieure à la température de consigne Ta. Cela signifie que, lorsque la température critique Tc1 de la portion P est égale à la première valeur T1, la portion P n'est pas supraconductrice.

La deuxième valeur T2 est strictement supérieure à la température de consigne Ta. Cela signifie que, lorsque la température critique Tc1 de la portion P est égale à la deuxième valeur T2, la portion P est supraconductrice.

L'organe de polarisation 30 est propre à générer un effet Josephson alternatif dans l'empilement 15. Cela signifie que l'organe de polarisation 30 est propre à imposer une première différence de potentiel V1 entre la première électrode 55 et la deuxième électrode 58.

L'organe de polarisation 30 est une alimentation électrique. Par exemple, l'organe de polarisation 30 est propre à convertir une tension d'alimentation reçue d'un réseau de distribution d'électricité en la première différence de potentiel V1.

La première différence de potentiel V1 est choisie dans une première gamme de valeurs G1. La première différence de potentiel V1 est propre à provoquer l'apparition d'un premier courant électrique C1 entre la première électrode 55 et la deuxième électrode 58.

Le premier courant électrique C1 présente une première intensité I1. La première intensité I1 est une intensité variable présentant une première fréquence F1. Cela signifie que le premier courant électrique C1 présente au moins une composante alternative, c'est-à-dire que le premier courant électrique C1 peut être décrit comme étant la somme d'un courant continu et d'un courant alternatif présentant la première fréquence F1.

En variante ou en complément, l'organe de polarisation 30 est propre à imposer une valeur de la première intensité I1 du premier courant électrique C1. Dans ce cas, la valeur de la première différence de potentiel V1 est libre de varier.

L'organe de polarisation 30 est, en outre, propre à contrôler la direction de la polarisation PE de la couche barrière 50.

Par exemple, l'organe de polarisation 30 est propre à contrôler la direction de la polarisation PE via une impulsion de tension entre la première électrode 55 et la deuxième électrode 58. Cela signifie que l'organe de polarisation 30 est configuré pour imposer, pendant une durée temporelle prédéterminée, une deuxième différence de potentiel V2 entre la deuxième face 67 de la couche barrière et la troisième face 68 de la couche barrière 50.

Par exemple, l'organe de polarisation 30 est configuré pour générer un deuxième courant électrique C2 entre la première électrode 55 et la deuxième électrode 58.

Le deuxième courant électrique C2 traverse successivement la première électrode 55, la première couche 40, la couche barrière 50, la deuxième couche 45 et la deuxième électrode 58.

Si la barrière 50 est isolante, le deuxième courant électrique C2 traverse la couche barrière 50 par effet tunnel. Cela signifie que des paires de Cooper traversent, par effet tunnel, la couche barrière 50. La distance que les paires de Cooper traversent par effet tunnel est la troisième épaisseur e3.

Le deuxième courant électrique C2 présente une deuxième intensité I2.

L'organe de polarisation 30 est propre à faire varier le sens du deuxième courant électrique C2 entre un premier sens et un deuxième sens opposé au premier sens.

Lorsque le deuxième courant électrique C2 circule dans le premier sens, la deuxième différence de potentiel V2 présente un premier signe. Lorsque le deuxième courant électrique C2 circule dans le deuxième sens, la deuxième différence de potentiel V2 présente un deuxième signe opposé au premier signe.

La deuxième différence de potentiel V2 est choisie dans une deuxième gamme G2 de valeurs.

Lorsque la deuxième différence de potentiel V2 est choisie dans la deuxième gamme G2, la deuxième différence de potentiel V2 est propre à contrôler la direction de la polarisation PE.

Chaque valeur de la deuxième gamme G2 est strictement supérieure, en valeur absolue, à chaque valeur de la première gamme G1.

L'organe de polarisation 30 est connecté électriquement à la première électrode 55 et à la deuxième électrode 58 par deux conducteurs respectifs.

Le fonctionnement du dispositif 10 va maintenant être décrit.

Dans un état initial, la polarisation électrique présente la première orientation O1.

Le module d'émission 20 est inactif. Cela signifie que le rayonnement R n'illumine pas l'empilement 15. Par exemple, le rayonnement R n'est pas généré par le module d'émission 20. En variante, le rayonnement R est généré par le module d'émission 20, mais n'est pas transmis jusqu'à l'empilement 15.

Dans une première étape, l'organe de polarisation 30 impose la première différence de potentiel V1 entre la première électrode 55 et la deuxième électrode 58. Par effet Josephson alternatif, le premier courant électrique C1 est alors généré.

Cette étape correspond au régime de fonctionnement connu pour les jonctions Josephson, appelé « alimentation ».

Le premier courant électrique C1 qui circule entre la première électrode 55 et la deuxième électrode 58 résulte d'une superposition des effets de polarisation par l'organe de polarisation 30 et de la polarisation électrique PE.

La première fréquence F1 est déduite de l'équation (2).

Dans une deuxième étape, appelée « configuration de barrière », l'organe de polarisation 30 impose une impulsion de tension entre la deuxième face 67 et la troisième face 68. Cela signifie que l'organe de polarisation 30 impose la deuxième différence de potentiel V2 entre la deuxième face 67 et la troisième face 68 pendant une durée temporelle D.

La durée temporelle D est, par exemple, comprise entre 1 picoseconde (ps) et 5 ps. En variante, la durée temporelle D est supérieure à 5 ps, par exemple supérieure à 1 nanoseconde (ns).

Pendant la durée temporelle D, la deuxième différence de potentiel V2 est, par exemple, constante à 10 pourcents (%) près.

L'impulsion de tension modifie l'orientation de la polarisation électrique PE de la couche barrière 50.

Par exemple, lorsque le signe de la deuxième différence de potentiel V2 est positif, la polarisation PE est pivotée depuis la première orientation O1 jusqu'à la deuxième orientation O2.

La polarisation PE provoque l'accumulation de charges électriques dans une portion P de la première couche 40.

La portion P est sensiblement planaire.

La portion P est perpendiculaire à la direction d'empilement Z.

La portion P est délimitée, selon la direction d'empilement Z, par la couche barrière 50.

La portion P présente une épaisseur primaire ep. L'épaisseur ep de la portion P est de l'ordre de la longueur de Thomas-Fermi dans le premier matériau M1, qui est d'environ 1 à 2 nm lorsque le premier matériau M1 est un matériau cuprate supraconducteur.

L'accumulation de charge diminue la température critique Tc1 de la portion P depuis la deuxième valeur T2 jusqu'à la première valeur T1.

La première valeur T1 étant strictement inférieure à la température de consigne Ta, la portion P n'est donc pas supraconductrice lorsque la polarisation PE est dans la deuxième orientation O2.

Lorsque la durée D est écoulée, la première différence de potentiel V1 n'est plus imposée entre la deuxième face 67 et la troisième face 68 de la couche barrière 50.

La polarisation PE reste dans la deuxième orientation O2.

L'étape de « configuration de barrière » est alors achevée.

Pour observer la conséquence de cette configuration, une deuxième étape d'alimentation est mise en œuvre. L'organe de polarisation 30 impose la première différence de potentiel V1.

La portion P n'étant pas supraconductrice, les paires de Cooper traversent la portion P par effet tunnel ou par conduction électrique classique. La distance totale traversée, par effet tunnel ou par conduction électrique, par les paires de Cooper est donc égale à la somme entre la troisième épaisseur e3 et l'épaisseur primaire ep.

Ainsi, la première intensité I1 est diminuée par rapport à la première intensité I1 mesurée lorsque la polarisation PE est dans la première orientation.

Le premier courant électrique C1 présente alors une troisième intensité I3. La troisième intensité I3 est inférieure à la première intensité I1. La résistance normale R de l'empilement 15 est donc augmentée.

Si l'organe de contrôle impose une valeur de la première intensité I1 supérieure au courant critique Ic, la première différence de potentiel V1 est alors non-nulle.

Lorsque la polarisation PE est dans la deuxième orientation O2, la première différence de potentiel V1 est supérieure à la première différence de potentiel V1 observée pour le même courant I1 lorsque la polarisation PE est dans la première orientation O1.

La première fréquence F1 du premier courant I1 est également augmentée, en accord avec l'équation (2) ci-dessus.

Ensuite, l'étape de « configuration de barrière » est mise en œuvre à nouveau pour revenir à la situation initiale.

Lors de cette deuxième étape de « configuration de barrière », l'impulsion de courant est inversée. Cela signifie que, lors de l'impulsion de courant, le signe de la deuxième différence de potentiel V2 est négatif. La valeur absolue de la deuxième différence de potentiel V2 est inchangée. Le deuxième courant C2 circule dans le deuxième sens pendant la durée temporelle D.

La polarisation PE pivote depuis la deuxième orientation O2 jusqu'à la première orientation O1.

Les charges accumulées dans la portion P sont évacuées à travers la première couche 40 et la première électrode 55.

La portion P est donc à nouveau supraconductrice.

Lorsqu'une nouvelle étape d'alimentation est mise en œuvre, le premier courant électrique C1 présente donc la première intensité I1.

Au cours d'une étape d'illumination, l'organe de polarisation 30 est désactivé, c'est-à-dire que l'organe de polarisation 30 n'impose pas de différence de potentiel entre la première électrode 55 et la deuxième électrode 60.

Le module d'émission 20 est activé. Le rayonnement R illumine l'empilement 15.

Le rayonnement R est, au moins partiellement, absorbé par la couche barrière 50.

Par effet photovoltaïque, une troisième différence de potentiel V3 apparaît entre la deuxième face 67 de la couche barrière 50 et la troisième face 68 de la couche barrière 50.

La troisième différence de potentiel V3 dépend de la puissance Pu du rayonnement R. Par exemple, la troisième différence de potentiel V3 est égale à 5 millivolts (mV).

Un troisième courant électrique C3 est généré par effet Josephson. Le troisième courant électrique C3 traverse successivement la première électrode 55, la première couche 40, la couche barrière 50, la deuxième couche 45 et la deuxième électrode 58.

Le troisième courant électrique C3 présente une quatrième intensité I4. La quatrième intensité I4 est fonction de la troisième épaisseur e3 et de la densité de puissance Pu du rayonnement R.

Le troisième courant électrique C3 présente une composante alternative. La composante alternative du troisième courant électrique C3 présente une troisième fréquence F3. La troisième fréquence F3 dépend également de la densité de puissance Pu.

L'intensité du premier courant électrique C1 présente deux valeurs différentes selon l'orientation de la polarisation PE.

L'organe de polarisation 30 est apte à modifier l'intensité du premier courant C1 entre la première intensité I1 et la troisième intensité I3 par l'application d'une impulsion de tension. L'organe de polarisation 30 est également apte à modifier la fréquence de la composante alternative du premier courant C1. Le premier courant C1 est donc plus ajustable, à la fois en intensité et en fréquence, que les courants fournis par les dispositifs de l'état de la technique.

De plus, le dispositif 10 est apte à générer le troisième courant C3, grâce au rayonnement R, sans imposer de différence de potentiel à l'empilement 15. La troisième intensité I3 et la troisième fréquence F3 sont modifiables, par un utilisateur, en fonction de la densité de puissance Pu.

Le dispositif 10 est donc plus adaptable que les dispositifs de l'état de la technique.

Le dispositif 10 est avantageusement intégré dans un dispositif de commutation électrique tel qu'un transistor. Le dispositif de commutation est alors plus adaptable que les dispositifs de commutation de l'état de la technique, en particulier du point de vue de l'intensité délivrée et de sa fréquence.

Il sera compris que différents matériaux sont utilisables pour la réalisation des différentes couches de l'empilement 15.

Par exemple, le premier matériau M1 est un matériau cuprate tel que l'oxyde mixte de Baryum, de formule $RBa_2Cu_3O_{7-\delta}$. Dans cette formule, « R » est une terre rare telle que, par exemple, l'Yttrium ou l'Europium.

Le deuxième matériau M2 est choisi parmi une grande variété de matériaux supraconducteurs.

Par exemple, le deuxième matériau M2 est le nitrure de niobium NbN, ou le siliciure de molybdène $Mo_{80}Si_{20}$.

En variante, le deuxième matériau M2 est un supraconducteur cuprate différent du premier matériau M1.

Selon une autre variante, le deuxième matériau M2 est identique au premier matériau M1. Dans ce cas, le dispositif 10 ne met pas en œuvre d'étape de « configuration de barrière ». Cependant, le dispositif 10 est toujours propre à générer le premier courant C1 ou, sous l'action du rayonnement R, le troisième courant C3.

Le troisième matériau M3 est un oxyde ferroélectrique tel que la ferrite de bismuth BiFeO3, le titanate de baryum $BaTiO_3$, ou le titano-zirconate de plomb PZT.

En variante, le troisième matériau M3 est un matériau apte à devenir ferroélectrique sous certaines conditions, tel que le titanate de strontium SrTiO3.

Selon une autre variante, s'il n'est pas prévu que le dispositif 10 mette en œuvre d'étape de « configuration de barrière », le troisième matériau M3 est choisi parmi tout matériau photovoltaïque non ferroélectrique.

L'énergie E du rayonnement R est sélectionnée en fonction de la valeur de gap G du troisième matériau M3. Par exemple, lorsque le troisième matériau M3 est BiFeO3, la valeur de gap vaut 2,8 eV, et l'énergie E est comprise entre 2,6 eV et 3,0 eV, de préférence strictement supérieure 2,8 eV.

Un deuxième exemple d'empilement 15 est représenté sur la figure 4.

Les éléments identiques au premier exemple de la figure 3 ne sont pas décrits à nouveau. Seules les différences sont mises en évidence.

Il est défini, pour le premier matériau M1, un plan ab. Le plan ab est un plan usuel défini pour de nombreuses structures cristallines dont la pérovskite.

La direction d'empilement Z n'est pas perpendiculaire à la première surface 65 du substrat 35.

De préférence, le troisième axe c du premier matériau M1 est perpendiculaire à la première face 65 du substrat 35, et le plan ab du premier matériau M1 n'est pas perpendiculaire à la direction d'empilement Z.

La première couche 40 comprend une première partie 80 et une deuxième partie 85.

La deuxième partie 85 et la première partie 80 sont venues de matière l'une avec l'autre.

La première partie 80 est délimitée, selon la direction d'empilement Z, par le substrat 35 et par la couche barrière 50.

Dans la première partie 80, la première épaisseur e1 de la première couche 40 varie de façon monotone dans une direction perpendiculaire à la direction d'empilement Z.

Par exemple, la première partie 80 est effilée, et la première épaisseur e1, présente, dans la première partie 80, une valeur maximale égale à 5 nm.

La première partie 80 et la couche barrière 50 sont superposées selon la direction d'empilement Z.

La première partie 80 présente une quatrième face 90.

La première partie 80 est réalisée en le premier matériau M1.

La première partie 80 comprend la portion P.

La quatrième face 90 délimite, selon la direction d'empilement Z, la couche barrière 50 et la première partie 80.

La quatrième face 90 n'est pas parallèle au plan ab du premier matériau M1. La quatrième face 90 n'est pas perpendiculaire au plan ab du premier matériau M1.

La deuxième partie 85 est définie selon une direction perpendiculaire à la première face 65 par le substrat 35.

La deuxième partie 85 et la couche barrière 50 ne sont pas superposées.

La deuxième partie 85 est sensiblement planaire.

La deuxième partie 85 est parallèle à la première face 65.

Dans la deuxième partie 85, la première épaisseur e1 est, par exemple, égale à 4 nm.

La deuxième partie 85 est réalisée en le premier matériau M1.

Le fonctionnement du deuxième exemple est identique au fonctionnement du premier exemple.

La direction d'empilement Z n'étant pas perpendiculaire au plan ab du premier matériau M1 qui présente une structure pérovskite, le couplage Josephson entre la première couche 40 et la deuxième couche 45 est augmenté.

Le courant critique Ic de l'empilement 15 est donc augmenté. Par conséquent, à première différence de potentiel V1 égale, la première intensité I1 et la troisième intensité I3 sont supérieures respectivement à la première intensité I1 et à la troisième intensité I3 du premier exemple.

De même, à densité de puissance Pu égale, la quatrième intensité I4 est supérieure à la quatrième intensité I4 du premier exemple.

Dans un troisième exemple de réalisation, la deuxième couche 45 est transparente au rayonnement R. Les éléments identiques au premier exemple de la figure 3 ne sont pas décrits à nouveau. Seules les différences sont mises en évidence.

Il est entendu par l'expression « couche transparente au rayonnement R » que la couche est propre à permettre la propagation du rayonnement R entre une première face de la couche et une deuxième face de la couche.

De préférence, la première couche 40 est transparente au rayonnement R.

La deuxième électrode 58 est transparente au rayonnement R.

Le module d'émission 20 est propre à illuminer l'empilement 15 avec le rayonnement électromagnétique R selon une direction parallèle à la direction d'empilement Z.

Le fonctionnement du troisième exemple est identique au fonctionnement du premier exemple.

Le dispositif 10 est alors plus aisé à réaliser. En particulier, le troisième exemple ne suppose pas que l'empilement 15 soit préparé pour permettre son illumination, par le rayonnement R, dans un plan perpendiculaire à la direction d'empilement Z.

**Revendications**

1. Dispositif électronique (10) comprenant :

   - un empilement (15) de couches superposées selon une direction d'empilement (Z), l'empilement (15) comportant

      - une première couche (40) réalisée en un premier matériau (M1) supraconducteur,
      - une deuxième couche (45) réalisée en un deuxième matériau (M2) supraconducteur, et
      - une couche barrière (50), délimitée selon la direction d'empilement (Z) par la première couche (40) et la deuxième couche (45), la couche barrière (50) formant une barrière entre la première couche (40) et la deuxième couche (45), la couche barrière (50) étant réalisée en un troisième matériau (M3) ferroélectrique présentant une valeur de gap (G),

   la première couche (40), la couche barrière (50) et la deuxième couche (45) formant une jonction Josephson,
   le premier matériau (M1) comportant au moins une portion (P) présentant une première température critique (Tc1),
   le dispositif électronique (10) étant **caractérisé en ce que** le dispositif (10) comprend, en outre :

      - un organe de régulation (25) propre à maintenir l'empilement (15) à une température de consigne (Ta), et
      - un organe de polarisation (30) propre à modifier la première température critique (Tc1) de la au moins une portion (P) de la première couche (40) entre une première valeur (T1) et une deuxième valeur (T2), la première valeur (T1) étant strictement inférieure à la température de consigne (Ta) et la deuxième valeur (T2) étant strictement supérieure à la température de consigne (Ta).

2. Dispositif selon la revendication 1, comprenant en outre un module d'émission (20) propre à illuminer l'empilement (15) avec un rayonnement électromagnétique (R) présentant une énergie photonique (E) supérieure ou égale à la valeur de gap (G) du troisième matériau (M3).

3. Dispositif selon la revendication 1 ou 2, dans lequel le premier matériau (M1) est différent du deuxième matériau (M2).

4. Dispositif selon l'une quelconque des revendications 1 à 3, dans lequel le premier matériau (M1) est l'oxyde mixte de baryum, de cuivre et d'yttrium.

5. Dispositif selon l'une quelconque des revendications 1 à 4, dans lequel le troisième matériau (M3) présente une polarisation électrique (PE) mobile entre une première orientation (O1) dans laquelle la polarisation électrique (PE) présente au moins une composante (C) parallèle à la direction d'empilement (Z) et une deuxième orientation (O2) et opposée à la première orientation (O1).

6. Dispositif selon l'une quelconque des revendications 1 à 5, dans lequel le troisième matériau (M3) est la ferrite de bismuth.

**7.** Dispositif selon l'une quelconque des revendications 1 à 6, dans lequel la première couche (40) présente une première épaisseur (e1) selon la direction d'empilement (Z), la première épaisseur (e1) variant de façon monotone dans une direction perpendiculaire à la direction d'empilement (Z).

**8.** Dispositif selon l'une quelconque des revendications 1 à 7, dans lequel l'empilement (15) comporte, en outre :

- une première électrode (55) et
- une deuxième électrode (58), et

le dispositif (10) comprenant, en outre, un organe de polarisation (30) propre à générer un courant électrique (C1) traversant au moins la première électrode (55), la couche barrière (50) et la deuxième électrode (58).

**9.** Transistor comprenant un dispositif (10) selon l'une quelconque des revendications 1 à 8.

**Patentansprüche**

**1.** Elektronische Vorrichtung (10), welche aufweist:

- einen Stapel (15) an Schichten, welche entlang einer Stapelrichtung (Z) gestapelt sind, wobei der Stapel (15) aufweist

- eine erste Schicht (40), welche aus einem supraleitenden ersten Material (M1) hergestellt ist,
- eine zweite Schicht (45), welche aus einem supraleitenden zweiten Material (M2) hergestellt ist, und
- eine Barriere-Schicht (50), welche entlang der Stapelrichtung (Z) von der ersten Schicht (40) und der zweiten Schicht (45) begrenzt wird, wobei die Barriere-Schicht (50) eine Barriere zwischen der ersten Schicht (40) und der zweiten Schicht (45) bildet, wobei die Barriere-Schicht (50) aus einem ferroelektrischen dritten Material (M3) hergestellt ist, welches einen Lückenwert (G) hat,

wobei die erste Schicht (40), die Barriere-Schicht (50) und die zweite Schicht (45) einen Josephson-Übergang bilden, wobei das erste Material (M1) mindestens einen Abschnitt (P) aufweist, welcher eine erste kritische Temperatur (Tc1) hat, und wobei die elektronische Vorrichtung (10) **dadurch gekennzeichnet ist, dass** die Vorrichtung (10) ferner aufweist:

- ein Regelungselement (25), welches imstande ist, den Stapel (15) bei einer Solltemperatur (Ta) zu halten, und
- ein Polarisationselement (30), welches imstande ist, die erste kritische Temperatur (Tc1) des mindestens einen Abschnitts (P) der ersten Schicht (40) zwischen einem ersten Wert (T1) und einem zweiten Wert (T2) zu variieren, wobei der erste Wert (T1) strikt kleiner als die Solltemperatur (Ta) ist und der zweite Wert (T2) strikt größer als die Solltemperatur (Ta) ist.

**2.** Vorrichtung gemäß Anspruch 1, welche ferner ein Emissionsmodul (20) aufweist, welches imstande ist, den Stapel (15) mit einer elektromagnetischen Strahlung (R) anzustrahlen, welche eine Photonenenergie (E) hat, welche größer oder gleich dem Lückenwert (G) des dritten Materials (M3) ist.

**3.** Vorrichtung gemäß Anspruch 1 oder 2, wobei das erste Material (M1) verschieden vom zweiten Material (M2) ist.

**4.** Vorrichtung gemäß irgendeinem der Ansprüche 1 bis 3, wobei das erste Material (M1) ein Mischoxid von Barium, Kupfer und Yttrium ist.

**5.** Vorrichtung gemäß irgendeinem der Ansprüche 1 bis 4, wobei das dritte Material (M3) eine elektrische Polarisation (PE) hat, welche zwischen einer ersten Ausrichtung (O1), in welcher die elektrische Polarisation (PE) mindestens eine zur Stapelrichtung (Z) parallele Komponente (C) hat, und einer zweiten Ausrichtung (O2), welche der ersten Ausrichtung (O1) entgegengesetzt ist, beweglich ist.

**6.** Vorrichtung gemäß irgendeinem der Ansprüche 1 bis 5, wobei das dritte Material (M3) Bismutferrit ist.

**7.** Vorrichtung gemäß irgendeinem der Ansprüche 1 bis 6, wobei die erste Schicht (40) eine erste Dicke (e1) entlang der Stapelrichtung (Z) hat, wobei die erste Dicke (e1) auf eine monotone Weise in einer Richtung, welche senkrecht zur Stapelrichtung (Z) ist, variiert.

8. Vorrichtung gemäß irgendeinem der Ansprüche 1 bis 7, wobei der Stapel (15) ferner aufweist:

   - eine erste Elektrode (55) und
   - eine zweite Elektrode (58) und

   wobei die Vorrichtung (10) ferner ein Polarisationselement (30) aufweist, welches imstande ist, einen elektrischen Strom (C1) zu erzeugen, welcher durch zumindest die erste Elektrode (55), die Barriere-Schicht (50) und die zweite Elektrode (58) fließt.

9. Transistor, welcher eine Vorrichtung (10) gemäß irgendeinem der Ansprüche 1 bis 8 aufweist.

**Claims**

1. Electronic device (10) comprising:

   - a stack (15) of layers superposed in a stacking direction (Z), the stack (15) comprising

       - a first layer (40) made of a first superconducting material (M1),
       - a second layer (45) made of a second superconducting material (M2), and
       - a barrier layer (50) delimited in the stacking direction (Z) by the first layer (40) and the second layer (45), the barrier layer (50) forming a barrier between the first layer (40) and the second layer (45), the barrier layer (50) being made of a third ferroelectric material (M3) having a gap value (G),

   the first layer (40), the barrier layer (50) and the second layer (45) forming a Josephson junction,
   the first material (M1) comprising at least one portion (P) having a first critical temperature (Tc1), the electronic device (10) being **characterised in that** the device (10) further comprises:

       - a regulating member (25) capable of maintaining the stack (15) at a setpoint temperature (Ta), and
       - a polarisation member (30) capable of modifying the first critical temperature (Tc1) of the at least one portion (P) of the first layer (40) between a first value (T1) and a second value (T2), the first value (T1) being strictly below the setpoint temperature (Ta) and the second value (T2) being strictly above the setpoint temperature (Ta).

2. Device according to claim 1, further comprising an emission module (20) capable of irradiating the stack (15) with electromagnetic radiation (R) having a photon energy (E) greater than or equal to the gap value (G) of the third material (M3).

3. Device according to claim 1 or 2, wherein the first material (M1) is different from the second material (M2).

4. Device according to any one of claims 1 to 3, wherein the first material (M1) is the mixed oxide of barium, copper and yttrium.

5. Device according to any one of claims 1 to 4, wherein the third material (M3) has an electric polarisation (PE) which is movable between a first orientation (O1) in which the electric polarisation (PE) has at least one component (C) parallel to the stacking direction (Z) and a second orientation (O2) and opposite to the first orientation (O1).

6. Device according to any one of claims 1 to 5, wherein the third material (M3) is bismuth ferrite.

7. Device according to any one of claims 1 to 6, wherein the first layer (40) has a first thickness (e1) in the stacking direction (Z), the first thickness (e1) varying monotonically in a direction perpendicular to the stacking direction (Z).

8. Device according to any one of claims 1 to 7, wherein the stack (15) further comprises:

   - a first electrode (55) and
   - a second electrode (58), and

the device (10) further comprising a polarisation member (30) capable of generating an electric current (C1) which passes through at least the first electrode (55), the barrier layer (50) and the second electrode (58).

9. Transistor comprising a device (10) according to any one of claims 1 to 8.

**FIG.1**

## FIG.2

## FIG.3

## FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015380631 A1

- JP H06334231 A

**Littérature non-brevet citée dans la description**

- **DE YANG et al.** The structural and superconducting properties in the YBa2Cu307-d/BiFeO3 heterostructures. *Physica C,* vol. 492, 181-185

- **NAVARRO et al.** Characterization of the insulator barrier and the superconducting transition temperature in GdBa2Cu307-d/BaTiO3 bilayers for application in tunnel junctions. *JAP,* vol. 118, 045308